# EUROPEAN PATENT SPECIFICATION

(11) **EP 1 507 900 B1**
(45) Date of publication and mention of the grant of the patent: **11.05.2011**
(21) Application number: 03725503.1
(22) Date of filing: 21.05.2003
(51) Int. Cl.: C25D 7/06

(54) **COPPER LAMINATE, COMPOSITE LAMELLAR MATERIAL COMPRISING SAID COPPER LAMINATE AND A PROCEDURE FOR PRODUCING IT**
KUPFERLAMINAT, LAMELLARES VERBUNDMATERIAL DIESES KUPFERLAMINAT ENTHALTEND UND EIN VERFAHREN FÜR DESSEN PRODUKTION
PRODUIT STRATIFIE EN CUIVRE, MATIERE LAMELLAIRE COMPOSITE CONTENANT LEDIT PRODUIT EN CUIVRE ET PROCEDE DE PRODUCTION CORRESPONDANT

(30) Priority: 23.05.2002 ES 200201271
(43) Date of publication of application: 23.02.2005
(73) Proprietor: Rodriguez Siurana, Antonio, 08110 Montcada 1 Reixac (ES); Balsells Coca, Felip, 08110 Montcada 1 Reixac (ES)
(72) Inventor: Rodriguez Siurana, Antonio, 08110 Montcada 1 Reixac (ES); Balsells Coca, Felip, 08110 Montcada 1 Reixac (ES)
(74) Representative: Ponti Sales, Adelaida
(86) International application number: PCT/IB2003/002122
(87) International publication number: WO 2003/100138

(56) References cited:
- GB-A- 1 137 960
- US-A- 3 998 601
- US-A- 4 387 006
- US-A- 5 712 047
- US-A1- 2002 011 418

## Description

### FIELD OF THE INVENTION

This invention relates to a copper laminate of great thickness, a composite lamellar material comprising said copper laminate especially for use in printed circuit boards, and to a procedure for producing said composite lamellar material.

### BACKGROUND OF THE INVENTION

The copper laminates described in the literature are usually manufactured from ingots of copper which are rolled down to a thickness suitable for the subsequent application for which they are to be used. Depending on the desired final thickness, the copper ingot is subjected to the rolling and annealing operations as often as necessary to produce the right thickness.

Copper laminates are a basic component in the manufacture of printed circuit boards.

Printed circuits are manufactured by packing sheets of glass cloth, glass paper, cellulose paper or the like, impregnated with a resin such as an epoxy, phenolic or polyester resin, etc. A copper laminate and, optionally, a second side of copper, of the same or different thickness or a lamina of another different metal is also added to one of the sides of this packing. The copper laminates will subsequently serve for forming the tracks of the printed circuit. A second lamina of a metal other than copper can also be used for various purposes, for example to act as a heat dissipater.

Once formed, the packing is subjected to heat and pressure, generally in a press, in order to cure the resin and so obtain a composite lamellar material from which the boards are cut for printed circuits of the desired size.

There exist different composite lamellar materials whose supports, base sheets or resins with which said base sheets are impregnated can be of different materials depending on the final application for which said composite lamellar materials are to be used.

This invention relates, more particularly, to the lamina of copper included in said composite lamellar material, independently of the rest of the composition of the composite lamellar material used for the unit as a whole.

In general, the thickness of the copper laminate used in the composite lamellar material varies depending on the field of application of the printed circuit boards, and is increased if the tracks of the printed circuits are to withstand a higher current charge.

The industrial procedures used in the state of the art to manufacture a copper laminate are based on electroplating procedures, especially for manufacturing laminates for printed circuits, and on rolling procedures, i.e. rolled copper, particularly for other industrial uses and for printed circuits with a great thickness of copper.

Thus, EP0181430 teaches that good adhesive and dendritic plating coverage results can be obtained by plating a foil surface(s) with a copper layer having a thickness in the range of about 0.01 µm to 1.0 µm. This copper layer or copper strike may be formed by passing the foil into a electrolyte solution. It is believed that this treatment reduces the number of bare spots or unplated regions because a fresh metal layer is provided on each surface to be treated. The fresh metal layer is believed to render the surface more uniformly electrochemically active and more receptive to subsequent electrolytic treatments such as electrodepositing dendrites on the surface.

On the other hand, US-A-3998601, particularly the content of col.4, lines 35-56, teaches that in order to weld together all the discontinuities presented by a rolled metal substrate, the metal is electrodeposited thereon in the production of foils of conventional thicknesses. However in the production of ultrathin foils, the amount of metal deposited by electrodeposition is insufficient to allow for welding at such surface discontinuities in the substrate. In contrast, foils produced only by electrodeposition present a highly uniform continuous surface for the formation of ultrathin metal deposits. The content of col.5, line 19, teaches that the ultrathin copper layer is about 2-12 microns thick.

A copper laminate made by electroplating has high purity and optimum surface quality: the inner side is shiny, due to it being in contact with the drum which acts as a cathode, while the outer side is matt and rough and is usually treated to improve its adherence to the substrate.

The manufacturing of copper laminates by electroplating is not usually carried out for thicknesses greater than 210 micrometers, basically for economic reasons.

A copper laminate made by rolling also has high purity, though lower surface quality, and an identical appearance on both sides, so that one of the sides has to be treated in order to provide satisfactory adherence. The purpose of this treatment is to increase the surface roughness and physicochemical compatibility with the substrate, properties necessary to achieve suitable copper/substrate adherence to lend this composite lamellar material resistance to the subsequent processes it will undergo during manufacturing of the printed circuit and in the course of its useful life. Among the most widely used subsequent processes are, for example, thermal shocks, punching, chemical etching, bending at 180°, etc., which requires a primary mechanical treatment of the surface and subsequent (optional) application of a suitable adhesive.

Alternatively, a chemical or electrochemical treatment can be carried out to deposit copper crystals and/or other elements such as Zn, As, etc., generally of dendritic morphology.

In a schematic way, in order to achieve good copper/substrate adherence the following factors are necessary:
1. Roughness of the side of the copper that will adhere to the substrate;
2. Physicochemical compatibility of the copper with the resins of the substrate and with the substrate itself; and
3. Possibly, an adhesive, if there is not good physicochemical compatibility or if the resins contained in the substrate are not adherent enough to provide the necessary adherence between the copper and the substrate.

It is therefore possible to obtain laminated copper of different qualities, thicknesses and degrees of annealing, with the price per kilogram, before carrying out the treatment to improve the adherence for thicknesses of, for example, 400 micrometers, being of the order of one-third that of electroplated copper.

### DESCRIPTION OF THE INVENTION

The problem to be solved by this invention is to achieve a composite lamellar material, especially for printed circuit boards, in which the copper laminate has a thickness greater than 105 µm with better adherence after thermal shock and lower cost.

The solution is based on the fact that the inventors of this patent have identified that the addition of a layer of electroplated copper onto a layer of rolled copper permits elimination of the mechanical treatment required for rolled copper, and even elimination of the subsequent adhesive, where this is required, leaving the surface of the copper in optimum condition for application of a dendritic treatment by electroplating.

A first aspect of this invention relates to a copper laminate such as it is defined in claim 1.

Advantageously and in accordance with the first aspect of this invention, a copper laminate is obtained which has at least one surface with electroplated copper which confers a suitable roughness so that it is not necessary to apply another treatment such as mechanical treatment nor the addition of an adhesive or any other process or material in order to achieve good adherence of the copper laminate onto the surface to be attached to it.

Also advantageously, the electroplating stage ii) can be followed by a stage ii-a) which includes a dendritic treatment that improves still further the adherence of the copper laminate onto the surface to which it is to be attached.

A second aspect of this invention relates to a composite lamellar material, especially for printed circuit boards, such as it is defined in claim 3.

A third aspect of this invention relates to a procedure for obtaining said composite lamellar material, for printed circuit boards, such as it is defined in claim 7.

Advantageously, a composite lamellar material, as described in the second aspect of the invention, provides greater resistance to thermal shock due to it being a composite lamellar material that does not require the presence of a material as a bonding element, in particular an adhesive, between the copper laminate and the insulating material or substrate formed by the combination of glass cloth and/or glass paper and epoxy or other resins, this being a weak point liable to lead to failures due to limitations in thermal resistance.

Advantageously, the lamellar material made in accord with the invention provides greater resistance to mechanical punching impact due to it being a material in which the adherence of the copper to the substrate is greater than that of a rolled copper with standard mechanical treatment, this being a weak point of the unit liable to lead to failures due to limitations in punching impact resistance and electrical insulation faults due to the metallic particles created by said system.

Also advantageously, the composite lamellar material disclosed in this invention, which comprises at least one copper laminate of high thickness, is cheaper because, on the one hand, it reduces the amount of raw material used in the unit, in particular the adhesive, and on the other hand because it has a layer of rolled copper which reduces the cost when compared with the entire copper laminate being of electroplated copper, where the thicknesses exceed 105 micrometers.

Another additional advantage is that during the procedure for obtaining the composite lamellar material it is not necessary to carry out a mechanical process to achieve suitable roughness, nor any later process of applying an adhesive on one of the sides of the copper laminate.

Optionally, where better copper/substrate bonding is required, it is preferable to carry out a stage ii-a) of dendritic treatment between the copper electroplating stage ii) and the protective treatment stage iii).

Generally, said protective treatment relates to a passivation process for the purpose of preventing possible oxidation, stains and/or decolouration of the surface of the copper laminate and at the same time to keep the composite lamellar material as a whole in optimum condition for transportation and storage thereof.

Also optionally, after stage iii), independently of whether or not a stage ii-a) of dendritic treatment has been carried out, a stage iii-a) of application of an adhesive can be carried out in order to increase still further the adherence between the copper/substrate in composite lamellar materials that must not be subjected to high thermal shocks.

Advantageously, a stage ii-b) of deposition of a barrier layer can be carried out after the dendritic treatment stage ii-a) and before the protective treatment stage iii).

Highlighted below are the main advantages achieved with the invention:
- Compared with the utilisation of rolled copper alone:
   the composite lamellar material disclosed in the invention presents a copper laminate with greater roughness and anchorage force; better adherence after thermal shock by eliminating the presence of the adhesive in certain substrates; and greater resistance to punching impact by improving adherence even in substrates that require the adhesive inter-stage.
- Compared with the utilisation of rolled copper either with mechanical treatment and adhesive or with dendritic treatment: elimination of problems deriving from directional mechanical treatment of the surface of the copper, such as electrical insulation faults due to metallic particles incrusted in the substrate, since with the composite lamellar material of the invention it is not necessary to carry out mechanical treatment in order to achieve suitable copper/substrate adherence.
- And as regards utilisation of a copper laminate according to the invention: having an anisotropic, rough surface that is optimum for subsequent application of an electrochemical dendritic treatment without any prior surface treatment.
- Both the copper laminate and the composite lamellar material of which it is made: a major reduction in cost.

Before undertaking a detailed description of the embodiments of the invention, there follow definitions of the specific terms related with the main aspects thereof.

The term "great thickness" as used in this specification refers to thicknesses greater than 105 µm.

The term "thermal resistance" relates to the adherence of the copper to the insulating material or substrate, which conditions its use in certain applications.

The term "impact resistance" relates to the adherence of the copper to the insulating material after subjecting it to a punching process during manufacture of the printed circuit.

The term "insulating material or substrate" relates to a unit made up of at least one prepolymerised material (prepeg) comprising one or more supports selected from glass cloth and/or glass paper, cellulose paper or others, in which said supports are impregnated with at least one resin selected from epoxy, polyester, phenolic, polyamide or other resins, polyamide films, and in which said unit of at least one prepolymerised material has been pressed together with the copper laminate or laminates. Insulating material or substrate also means any other insulating material whose high electrical resistance is sufficient for the application required in the various uses of the printed circuits made from said materials.

### DESCRIPTION OF THE FIGURES

Figure 1 shows, schematically and solely by way of example, a preferred embodiment of the procedure for obtaining a copper laminate or a composite lamellar material of which it is made, especially for printed circuit boards, and in particular of stage ii) of electroplating of copper onto a rolled copper laminate i) and the protective treatment stage iii).

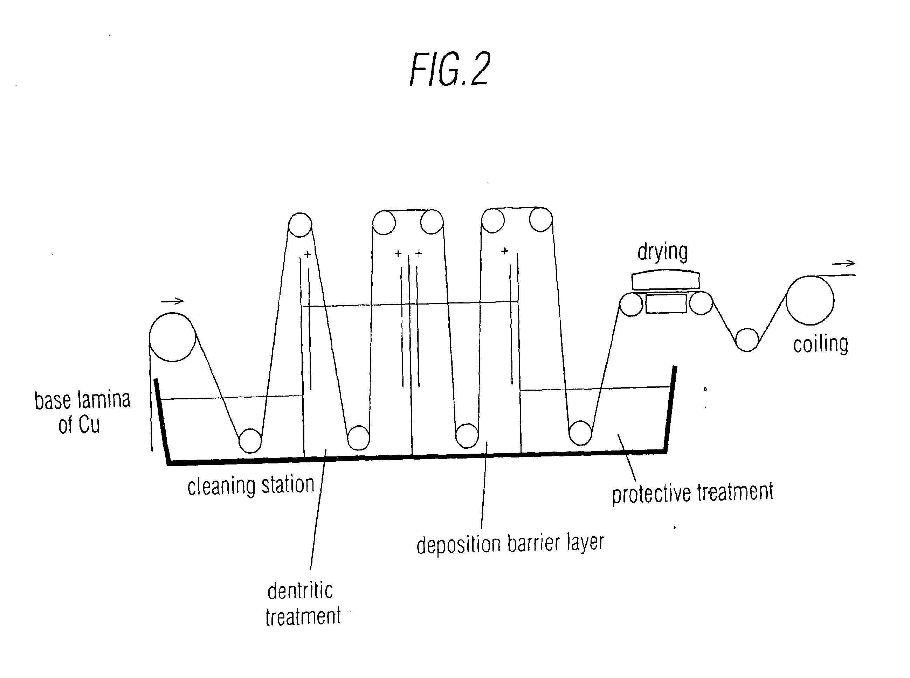

Figure 2 shows a preferred embodiment of the procedure for obtaining a composite lamellar material, in particular of stage ii-a) of dendritic treatment and of stage ii-b) of deposition treatment of a barrier layer followed by stage iii) of protective treatment.
Figure 3 shows a cross-section view of the copper laminate according to the first aspect of the invention, showing a layer of rolled copper 1, followed by a layer of electroplated copper 2 and an optional dendritic treatment 3.

There follows a description of preferred embodiments of invention, as non-restrictive examples of the scope of the invention.

### DETAILED DESCRIPTION OF THE INVENTION

The procedure object of this invention consists in the utilisation of a copper laminate, preferably continuous (strip) for economic reasons, produced by rolling, using procedures habitual in the industry, of suitable dimensions (width), generally between 500 mm and 1500 mm, though this width is not to the exclusion of others, and stage ii-a) of dendritic treatment and of stage ii-b) of deposition treatment of a barrier layer followed by stage iii) of protective treatment.

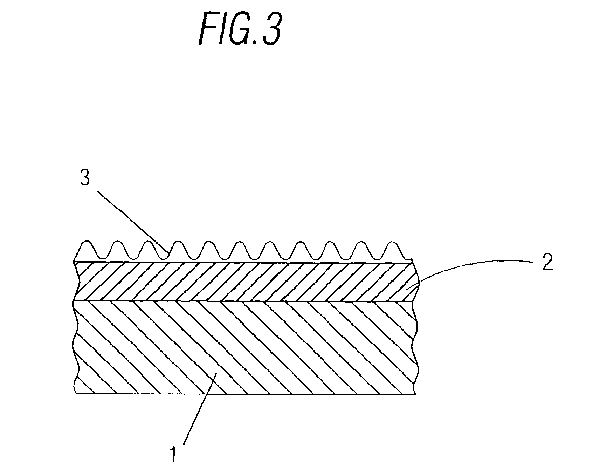

Figure 3 shows a cross-section view of the copper laminate according to the first aspect of the invention, showing a layer of rolled copper 1, followed by a layer of electroplated copper 2 and an optional dendritic treatment 3.

There follows a description of preferred embodiments of invention, as non-restrictive examples of the scope of the invention.

### DETAILED DESCRIPTION OF THE INVENTION

The procedure object of this invention consists in the utilisation of a copper laminate, preferably continuous (strip) for economic reasons, produced by rolling, using procedures habitual in the industry, of suitable dimensions (width), generally between 500 mm and 1500 mm, though this width is not to the exclusion of others, and having a thickness equal to or greater than 105 µm , upon which a layer of copper is deposited by electroplating to provide a rough surface of suitable morphology for subsequent or simultaneous application of a dendritic treatment, as is usually carried out with electroplated copper for use as a conducting surface on which the tracks of the printed circuits used very extensively in the electronics industry are laid.

The layer of electroplated copper can vary by a few micrometers, 5 micrometers, up to 70 micrometers, the thickness of the layer to be not supported by a metallic drum. The electrolytic tank is fed with a solution of copper salts at suitable pH, prepared in accordance with the state of the art. The level of current used together with the speed of drum rotation determines the thickness of the layer of copper deposited.

Once the layer of copper laminate plus the layer of electroplated copper emerge from the solution at the opposite side of the drum, the interior surface is smooth, as was the strip of rolled copper originally, while the exterior surface is rough as a result of the layer of electroplated copper, and thus in optimum condition for application, if required, of a dendritic, chemical or electrochemical treatment to improve or increase the specific area of the rough surface and thus optimise its properties in order to provide optimum adherence to the substrate of the insulating laminate to which it will adhere by means of a process of pressing at temperatures that usually range between 150 and 250°C.

Depending on the position of entry of the sheet of copper laminate into the solution, it may sometimes be necessary to protect the inner surface of the copper strip with a polymeric film to prevent the electrolytic solution being able to act upon the (bright) inner surface of the copper.

Use of the copper laminate as cathode means that the drum may be eliminated from the process, by submerging both sides in the solution in which the electroplating is to take place, without the protection of the drum on one of the sides, so that by utilisation of an anode of suitable design, or simply a double anode, electroplating can be carried out on both sides.

This process can also be carried out on discontinuous sheets. The copper laminate obtained by this process, comprising electroplated copper + rolled copper + electroplated copper is particularly useful in applications for "multilayer" type printed circuits, in which there are also conductive layers inside the lamellar material. The simplest multilayer would thus be composed of copper-substrate-copper-substrate-copper-substrate-copper, Which we would term "four-layer". Multilayers can also be manufactured with six, eight or more layers of copper, with no limitation on the number.

The dendritic treatment, generally carried out to improve still further the roughness and, therefore, the adherence of the surface of the copper in contact, usually, with the resin of the insulating laminate which acts as substrate, whether chemical or electrochemical, is not the object of this patent, so that any of the treatments carried out by manufacturers of copper sheeting by electroplating may be used. For merely informative purposes, however, we describe the basis of the treatment and explanation of its purpose.

### Dendritic treatment

Treatment of the continuous base laminate by means of a number of chemical and electrochemical stages.

Applied to the copper laminate, this treatment ensures high adherence of the copper to the insulating material or substrate and at the same time prevents stains and decolouring during transportation or storage.

Firstly, the base lamina is passed though a cleaning station.

A uniform layer of spherical microcrystalline copper/copper oxide dendrites is then deposited on the pyramidal structure of the base lamina, for two reasons:
a) To increase the roughness (improves the mechanical bond);
b) Size of the micro-crystalline surface (improves the chemical bond).

Optionally, deposition of a layer of zinc or brass which acts as a barrier layer allows any catalytic or inhibiting reaction of the crystals with the copper oxide on the resins to be prevented.

Finally, a protective treatment is implemented, usually a passivation process, on both surfaces of the copper laminate in order to prevent the excitation and corrosion which can take place during transportation and storage.

Although the main object of this invention is to produce a laminate of optimum quality for use in applications which require optimum copper-substrate adherence and high thermal shock and punching impact resistance, the invention has a significant economic aspect in that due to this procedure the copper laminate has a cost between 30% and 50% that of other procedures currently used in the industry, such as the use of electroplated copper alone, with or without dendritic treatment or chemical and/or electrochemical dendritic treatment on rolled copper.

### Examples

The starting-point is a strip of rolled copper of "semi-hard" quality, type E-Cu compliant with EN 1652, for better adaptation to the drum (cathode) in which the electroplating will take place, 1010 mm wide and 360 micrometers thick, with both surfaces duly degreased and free from organic impurities, fed into a decoiling machine with capacity for up to six tonnes.

In the wettability tests with calibrated inks it presented a wettability equal to or greater than 44 mN/m.

The matt-appearance surface of the copper presented a roughness of Ra 0.15 micrometers on both sides.

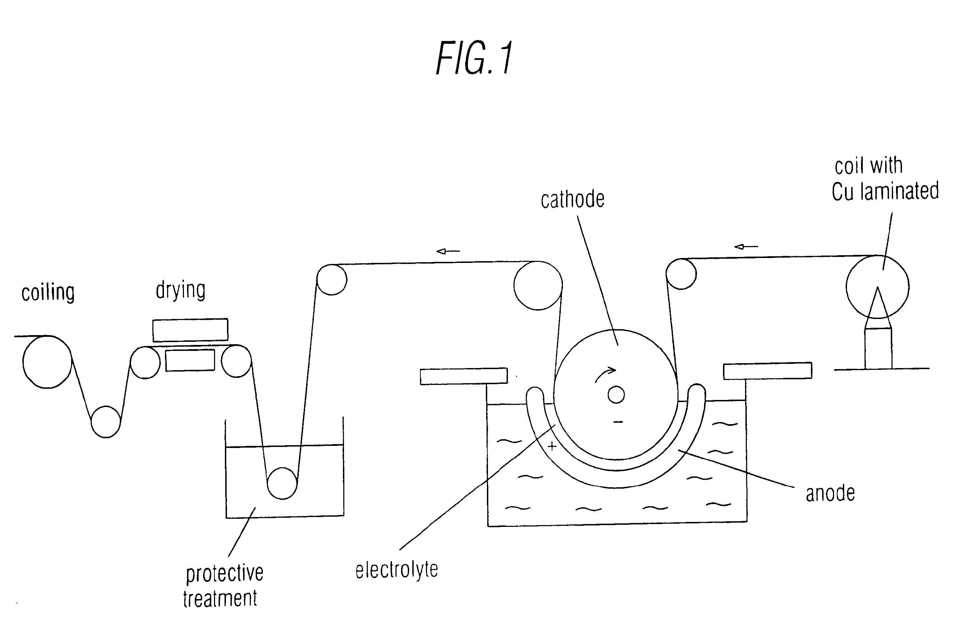

A roller system was used to bring the copper strip into close contact with the upper part of the drum, of the same width as the strip, clamping it in its circular shape as shown in Figure 1.

The lower part of the drum with the clamped strip was submerged inside the electrochemical cell through which an acid solution of copper sulphate prepared according to standard industry methods circulated. By way of example, in this embodiment the starting material was copper scrap of electrolytic quality, treated with hot sulphuric acid and with air bubbling.

The solution was filtered and purified, with checks made to ensure that the sulphuric acid and copper sulphate solution were suitable.

In this embodiment, the concentration of metallic copper per litre was 55 g. The concentration of sulphuric acid was 100 g/l and the working temperature 60°C.

The solution between anode and cathode was kept in turbulent state.

The electrical current applied was of the order of 50 A/dm² and the speed of the drum was adjusted so that 35 micrometers of electroplated copper were obtained on the outer surface of the rolled copper.

The copper obtained by this procedure had an outer electroplating-side roughness of Ra 1.35 micrometers, which can be sufficient for some uses as will be shown in the adherence results carried out with the final laminate.

The copper thus obtained was subject, as is usual practice with electroplated copper, to a treatment in which approximately 3 micrometers of dendritic-morphology copper crystals were first deposited and, in subsequent stages, zinc or other metals and silane were deposited in order to increase the specific surface area, improving attachment to the surface of the laminate, preventing contact of the copper crystals with potential resin catalysts, etc. The bright surface was protected from possible oxidation processes by light application of a chemical protector (benzotriazol) .

Following this subsequent electrochemical treatment, the rough outer surface of the copper presented a roughness of Ra 1.7 micrometers.

The copper thus obtained was cut into sheets which were laid on either side of the prepreg package, with the treated copper side in contact with the prepreg package, comprising 5 sheets of approximately 0.18 mm of glass cloth impregnated with an epoxy resin (prepreg type FR-4 compliant with standard IPC-4101) and subjected to a pressing process at a temperature of 167 °C and pressure of 20 bar.

The results obtained in terms of adherence following thermal shock were as set out comparatively in the table below.

**TABLE**

| Copper roll thickness, µm | 400 | - | 360 | 380 |
|---|---|---|---|---|
| Electroplated Cu thickness, µm | - | 400 | 35 | 20 |
| Average roughness, Ra, µm | 0.9 | 3.0 | 1.7 | 0.7 |
| Maximum roughness, Rmax., µm | 13 | 20 | 14 | 4.5 |
| Treatment | Mechanic al + Adhesive | Dendritic | Dendritic | - |
| Cu adherence to substrate FR-4, after 20"/260°C, N/mm | 5 | 11.5 | 11 | 6.5 |

## Claims

1. Copper laminate **characterised in that** it is obtained by the following stages:
i) rolling of a copper ingot to obtain a layer of copper of a thickness equal to or greater than 105 µm; and
ii) electroplating of copper to obtain a layer of copper of a thickness from 5 to 70 µm onto the layer of copper obtained in stage i).

2. Copper laminate according to Claim 1, **characterised in that** a subsequent stage ii-a) of dendritic treatment is carried out after the copper electroplating stage ii)
for increasing the adherence of the copper laminate onto the surface to which it is to be attached.

3. Composite lamellar material for printed circuit boards which comprises at least one copper laminate, **characterised in that** said copper laminate comprises a base layer of rolled copper at least 105 µm thick and a layer of electroplated copper of a thickness from 5 to 70 µm onto the layer of rolled copper, said composite lamellar material also comprising an insulating material or combination of insulating materials.

4. Composite lamellar material according to Claim 3, **characterised in that** said copper laminate has a thickness of between 110 µm and 500 µm.

5. Composite lamellar material according to Claim 3, **characterised in that** said layer of copper laminate has a thermal shock resistance exceeding 5 N/mm.

6. Composite lamellar material according to Claim 3, **characterised in that** said layer of copper laminate has a suitable punching mechanical impact resistance such that the copper/substrate adherence exceeds 5 N/mm.

7. Procedure for obtaining a composite lamellar material for printed circuit boards, as defined in any of the previous claims, **characterised in that** it comprises the following stages:
i) rolling of a copper ingot to obtain a copper laminate of a thickness equal to or greater than 105 µm;
ii) electroplating of copper to obtain a layer of copper of a thickness from 5 to 70 µm onto the rolled copper obtained in stage i) ;
iii) protective treatment; and
iv) addition of an insulating material or materials which include(s) one or more supports impregnated with a resin or mixture of resins; and
v) application of heat and pressure to the whole in order to cure said resins to provide the composite lamellar material.

8. Procedure according to Claim 7, **characterised in that** an additional stage ii-a) of dendritic treatment is carried out after the copper electroplating stage ii).

9. Procedure according to Claim 8, in which said stage ii-a) includes the deposition of crystals of dendritic morphology.

10. Procedure according to Claim 9, in which after stage ii-a) a stage ii-b) of deposition of a barrier layer is carried out.

11. Procedure according to any of Claims 7 to 10, **characterised in that** it comprises an additional stage iii-a) which consists in applying an adhesive between the copper and insulating material interface before applying heat and pressure to the whole.

12. Procedure according to Claim 7, **characterised in that** stage ii) is carried out in a non-metallic drum, with the copper laminate included on the layer of rolled copper acting as electrode.

13. Use of a copper laminate as defined in either of Claims 1 to 2 for the manufacture of printed circuits.

## Patentansprüche

1. Kupferlaminat, **dadurch gekennzeichnet, dass** es durch die folgenden Schritte erhalten wird:
i) Walzen eines Kupferbarrens, um eine Kupferschicht einer Dicke zu erhalten, die gleich oder größer ist als 105 µm ; und
ii) Galvanisieren des Kupfers, um eine Kupferschicht einer Dicke von 5 bis 70 µm auf der Kupferschicht, erhalten in Schritt i) zu erhalten.

2. Kupferlaminat nach Anspruch 1, **dadurch gekennzeichnet, dass** ein nachfolgender Schritt II-a) einer dendritischen Aufbereitung nach dem Kupfergalvanisierungsschritt ii) ausgeführt wird, um die Anhaftung des Kupferlaminats auf der Oberfläche, auf der es anhaftend gemacht werden soll, zu erhöhen.

3. Lamellares Verbundmaterial für Leiterplatten, das wenigstens ein Kupferlaminat aufweist, **dadurch gekennzeichnet, dass** das Kupferlaminat eine Basisschicht von gewalztem Kupfer mit wenigstens 105 µm Dicke und eine Schicht von galvanisiertem Kupfer einer Dicke von 5 bis 70 µm auf der Schicht des gewalztem Kupfers aufweist, wobei das lamellare Verbundmaterial auch ein Isoliermaterial oder eine Kombination von Isoliermaterialien aufweist.

4. Lamellares Verbundmaterial nach Anspruch 3, **dadurch gekennzeichnet, dass** das Kupferlaminat eine Dicke zwischen 110 µm und 500 µm aufweist.

5. Lamellares Verbundmaterial nach Anspruch 3, **dadurch gekennzeichnet, dass** die Schicht des Kupferlaminats eine Temperaturwechselbeständigkeit aufweist, die größer als 5 N/mm ist.

6. Lamellares Verbundmaterial nach Anspruch 3, **dadurch gekennzeichnet, dass** die Schicht des Kupferlaminats eine geeignete mechanische Stanz-Stoßfestigkeit derart aufweist, dass die Kupfer/Substrat-Anhaftung 5 N/mm übersteigt.

7. Verfahren zur Herstellung eines lamellaren Verbundmaterials für Leiterplatten, gemäß einem der vorhergehenden Ansprüche, **dadurch gekennzeichnet, dass** es die folgenden Schritte aufweist:
i) Walzen eines Kupferbarrens, um ein Kupferlaminat einer Dicke zu erhalten, die gleich oder größer als 105 µm ist;
ii) Galvanisieren von Kupfer, um eine Kupferschicht einer Dicke von 5 bis 70 µm auf das gewalzte Kupfer, erhalten in Schritt i), zu erhalten;
iii) Schutzbehandlung; und
iv) Zusetzen eines Isoliermaterials oder von Isoliermaterialien das/die eine oder mehrere Auflagen umfasst/umfassen, die mit einem Harz oder einer Mischung aus Harzen imprägniert ist/sind; und
v) Aufbringen von Wärme und Druck auf die Gesamtanordnung, um diese Harze auszuhärten, um das lamellare Verbundmaterial zu schaffen.

8. Verfahren nach Anspruch 7, **dadurch gekennzeichnet, dass** ein zusätzlicher Schritt ii-a) einer dendritischen Behandlung nach dem Kupfergalvanisierungsschritt ii) ausgeführt wird.

9. Verfahren nach Anspruch 8, bei dem der Schritt ii-a) die Ablagerung von Kristallen von dendritischer Morphologie umfasst.

10. Verfahren nach Anspruch 9, bei dem nach dem Schritt ii-a) ein Schritt ii-b) des Ablagerns einer Sperrschicht ausgeführt wird.

11. Verfahren nach einem der Ansprüche 7 bis 10, **dadurch gekennzeichnet, dass** es einen zusätzlichen Schritt iii-a) aufweist, der in der Aufbringung einer Haftschicht zwischen dem Kupfer und der Sperrmaterialzwischenschicht besteht, vor Aufbringen von Wärme und Druck auf die Gesamtanordnung.

12. Verfahren nach Anspruch 7, **dadurch gekennzeichnet, dass** der Schritt ii) in einer nicht metallischen Trommel ausgeführt wird, wobei das in der Schicht des gewalzten Kupfers enthaltene Kupferlaminat als Elektrode wirkt.

13. Verwendung eines Kupferlaminats gemäß einem der Ansprüche 1 oder 2 für die Herstellung von Leiterplatten.

## Revendications

1. Laminé de cuivre **caractérisé en ce qu'**il est obtenu par les étapes suivantes :
i) roulage d'un lingot de cuivre afin d'obtenir une couche de cuivre d'une épaisseur égale ou supérieure à 105 µm ; et
ii) placage électrolytique de cuivre afin d'obtenir une couche de cuivre d'une épaisseur de 5 à 70 µm sur la couche de cuivre obtenue à l'étape i).

2. Laminé de cuivre selon la revendication 1, **caractérisé en ce qu'**une étape suivante ii-a) de traitement dendritique est effectuée après l'étape de placage électrolytique du cuivre ii) pour augmenter l'adhérence du laminé de cuivre sur la surface à laquelle il doit être fixé.

3. Matériau lamellaire composite pour des cartes à circuits imprimés qui comprend au moins un laminé de cuivre, **caractérisé en ce que** ledit laminé de cuivre comprend une couche de base de cuivre roulé d'une épaisseur d'au moins 105 µm et une couche de cuivre plaqué électrolytiquement d'une épaisseur de 5 à 70 µm sur la couche de cuivre roulé, ledit matériau lamellaire composite comprenant également un matériau isolant ou une combinaison de matériaux isolants.

4. Matériau lamellaire composite selon la revendication 3, **caractérisé en ce que** ledit laminé de cuivre présente une épaisseur entre 110 µm et 500 µm.

5. Matériau lamellaire composite selon la revendication 3, **caractérisé en ce que** ladite couche de laminé de cuivre présente une résistance aux chocs thermiques supérieure à 5 N/mm.

6. Matériau lamellaire composite selon la revendication 3, **caractérisé en ce que** ladite couche de laminé de cuivre présente une résistance appropriée aux impacts mécaniques de poinçonnage de façon à ce que l'adhérence cuivre / substrat soit supérieure à 5 N/mm.

7. Procédure permettant d'obtenir un matériau lamellaire composite pour des cartes à circuits imprimés, tel que défini dans une des revendications précédentes, **caractérisée en ce qu'**elle comprend les étapes suivantes :
i) roulage d'un lingot de cuivre afin d'obtenir un laminé de cuivre d'une épaisseur égale ou supérieure à 105 µm ; et
ii) placage électrolytique de cuivre afin d'obtenir une couche de cuivre d'une épaisseur de 5 à 70 µm sur le cuivre roulé obtenu à l'étape i) ;
iii) traitement protecteur ; et
iv) ajout d'un ou plusieurs matériaux isolants qui comprennent un ou plusieurs supports imprégnés d'une résine ou d'un mélange de résines ; et
v) application de chaleur et de pression à l'ensemble afin de durcir lesdites résines et d'obtenir le matériau lamellaire composite.

8. Procédure selon la revendication 7, **caractérisée en ce qu'**une étape supplémentaire ii-a) de traitement dendritique est effectuée après l'étape de placage électrolytique ii).

9. Procédure selon la revendication 8, dans laquelle ladite étape ii-a) comprend la déposition de cristaux de morphologie dendritique.

10. Procédure selon la revendication 9, dans laquelle, après l'étape ii-a), une étape ii-b) de déposition d'une couche protectrice est effectuée.

11. Procédure selon l'une des revendications 7 à 10, **caractérisée en ce qu'**elle comprend une étape supplémentaire iii-a) qui consiste à appliquer un adhésif entre le cuivre et une interface de matériau isolant avant l'application de chaleur et de pression à l'ensemble.

12. Procédure selon la revendication 7, **caractérisé en ce que** l'étape ii) est effectuée dans un tambour non métallique, le laminé de cuivre étant inclus sur la couche de cuivre roulé agissant comme une électrode.

13. Utilisation d'un laminé de cuivre tel que défini dans une des revendications 1 ou 2 pour la fabrication de circuits imprimés.
